(19)

Europäisches
Patentamt

European
Patent Office

Office européen
des brevets

(11) **EP 1 306 682 B1**

(12) **EUROPEAN PATENT SPECIFICATION**

(45) Date of publication and mention
of the grant of the patent:
**16.11.2011 Bulletin 2011/46**

(51) Int Cl.:
***G01R 31/30*** *(2006.01)* ***G01R 27/18*** *(2006.01)*

(21) Application number: **02256753.1**

(22) Date of filing: **27.09.2002**

(54) **Circuit tester**

Schaltungsprüfeinrichtung

Testeur de circuit

(84) Designated Contracting States:
**AT BE BG CH CY CZ DE DK EE ES FI FR GB GR
IE IT LI LU MC NL PT SE SK TR**

(30) Priority: **02.10.2001 GB 0123651**

(43) Date of publication of application:
**02.05.2003 Bulletin 2003/18**

(73) Proprietor: **Robin Electronics Limited
Watford,
Hertfordshire WD18 9UA (GB)**

(72) Inventors:
• **Sehdev, Arun,
c/o Robin Electronics Limited
Watford, Hertfordshire WD18 9UA (GB)**

• **Hardy, William D.,
c/o Buckman-Hardy Associates
Deal, Kent CT14 9RD (GB)**

(74) Representative: **Shindler, Nigel
Brookes Batchellor LLP
102-108 Clerkenwell Road
London EC1M 5SA (GB)**

(56) References cited:
**EP-A- 0 881 500      GB-A- 2 292 225
US-B1- 6 288 553**

Printed by Jouve, 75001 PARIS (FR)

EP 1 306 682 B1

**Description**

This invention relates to electrical testing devices, and in particular, to a line earth loop tester which is adapted to perform measurements on a mains driven circuit, which may include residual current device (RCD), without tripping the RCD.

The established method of measuring the line earth loop resistance is to connect a load resistance across the line and earth leads and measure the voltage drop of the supply. From this voltage drop and the load current the resistance of the line earth loop can be calculated. However to overcome noise (including variations in the supply voltage) the load current must be sufficiently high to cause a voltage drop that is measurable with respect to this noise.

Conventional instruments use a brute force type approach with a test current which is typically about 25 amps, but with the increasing use of RCD's, there is a requirement not to trip a RCD that may be in circuit. These usually have a range of nominal values such as 30mA.

EP 0295800B ("D1") discloses a test instrument which introduces a ramped DC current that saturates the RCD to allow a high live-earth test current, however the large test current makes it relatively expensive to implement. Also there are still problems in ensuring that when the DC current is applied or removed it will not trip any RCD.

Another possibility is to reduce the test current to 15mA to avoid tripping the RCD. This method has some disadvantages, such as reading resolution ($1\Omega$/$0.1\Omega$) and long acquisition times, and is sensitive to system noise.

The present invention utilises micro processors to allow the use of all three wires (line, neutral and earth) of the supply to be used so that the line earth loop resistance can be calculated from a three wire network analysis.

US 6288553A discloses a method for determining earth loop resistance which involves loading the live-neutral circuit with a known resistance and then injecting a known small current into the live-earth circuit.

According to the present invention there is provided a method according to claim 1 and a test instrument according to claim 8.

Thus the measurement is carried out in two parts that can be treated separately, i.e. the high current line-neutral test, and then the low current neutral-earth test.

It will be noted that the line-neutral circuit can be measured at a high test current such as 25A as the current is not limited by the RCD. Two measurements can therefore be made of the voltage drop between line and neutral, and the voltage rise between neutral and earth when the line-neutral load resistor is connected.

In order to minimise the effects of drift of the supply voltage, the measurement of the loaded and unloaded half cycles should be close together, preferably sequential. A further development would be to use three sequential half cycles, the first and last unloaded and averaged, the middle half cycle being loaded. In order to reduce the effect of electrical noise on the supply several groups of readings are preferably taken and the results combined to give more accurate results.

To further reduce noise the test instrument may be designed to make a series of measurements at a somewhat lower current (e.g.10 amps) and may include a microprocessor arranged to apply statistical techniques. The standard deviation of the results may then be calculated and displayed. This can be used to instigate further measurements until a reliable result has been obtained. It is also possible to discard the extremes of the results if these significantly deviate from the average.

The low do test current which is applied for the neutral-earth test is subject to the limitations imposed by a RCD but because the neutral and earth are joined at the substation, they are nominally at the same potential and are not subject to noise from variations in the supply voltage to the substation.

In practice there is likely to be at least an order of magnitude less noise in the neutral-earth loop than in the line-neutral loop. This allows the measurement to be made at a lower test current and still achieve at least $10m\Omega$ resolution.

The low do test current may be derived from the mains supply or a battery. The consequent voltage rise between the earth and neutral terminals divided by the injected current gives the combined neutral and earth resistances, and thus by subtracting the neutral resistance found in the high current test the earth resistance is found. The earth and line resistances then give the line earth loop resistance.

The injected current is preferably kept below 15mA to prevent an RCD tripping or alternatively the techniques of D1 (i.e. ramping the current) can be employed to give a higher DC current. This higher DC current can also be used as the test current.

Preferably the DC is ramped so as to allow the application of a relatively high test current that may exceed the nominal rating of the RCD (e.g. if the RCD is rated at 30mA the ramped test current could be much higher than this but still not trip the RCD). This higher current gives a better volt drop and hence a better signal to noise ratio.

In the D1 technique the DC may be several amps as the objective is to saturate the RCD magnetic core. In the preferred method of the present invention the DC is not used to saturate the core so a lower DC can be used, but sufficiently high to give a good signal to noise ratio. As in the D1 technique the ramp rate may be determined by the RCD sense transformer. The DC is less sensitive to installation noise (generally AC, not pure DC) giving rise to a better, more stable measurement.

Preferably, the ramp rate of the DC current is programmable. The DC voltage between neutral and earth is then measured several times, a linear regression and standard deviation are calculated, and these give indications of any drift in the DC level, and noise on the measured values. These in turn give an indication of the reliability of the test results. These may be displayed and/or used to repeat measurements.

One embodiment of the invention will now be described, by way of example, with reference to the accompanying drawings, in which:

Figure 1 is a schematic diagram showing the connection of measuring devices to a circuit under test;
Figure 2 is a block diagram of a circuit for injecting a test current into the neutral earth loop;
Figure 3 is a block diagram of a line neutral test circuit; and
Figure 4 is a block diagram of a first part of a measurement circuit.

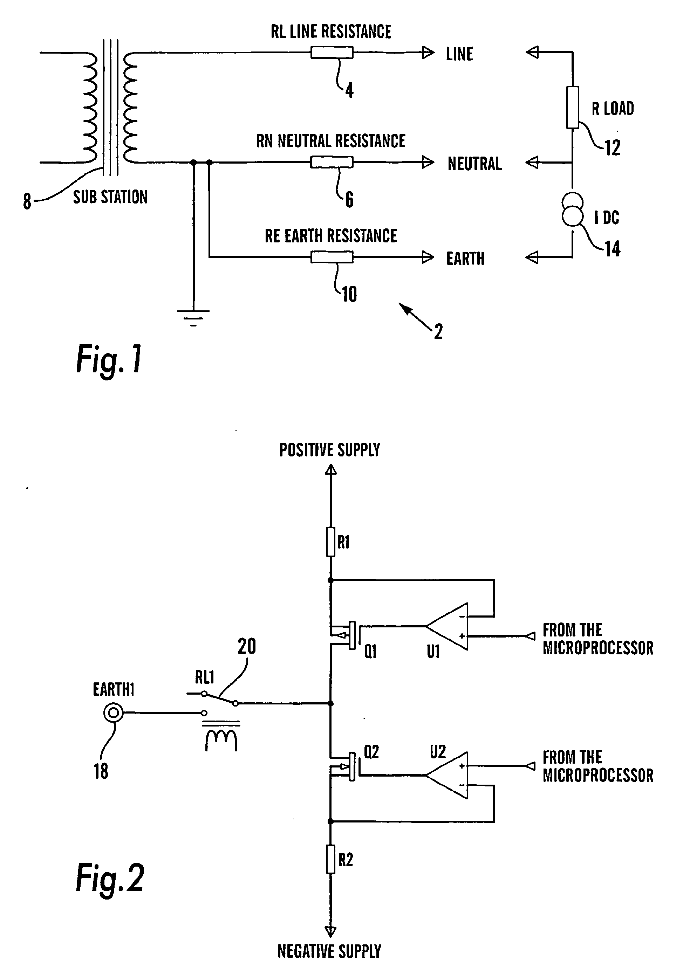

Referring to Figure 1, the circuit 2 under test comprises a line resistance 4, and a neutral resistance 6, connected to a sub-station transformer 8, and an earth resistance 10. In testing, a load resistor 12 is connected across the line and neutral terminals, while a current source 14 which supplies a current IDC, is connected across the neutral and earth terminals.

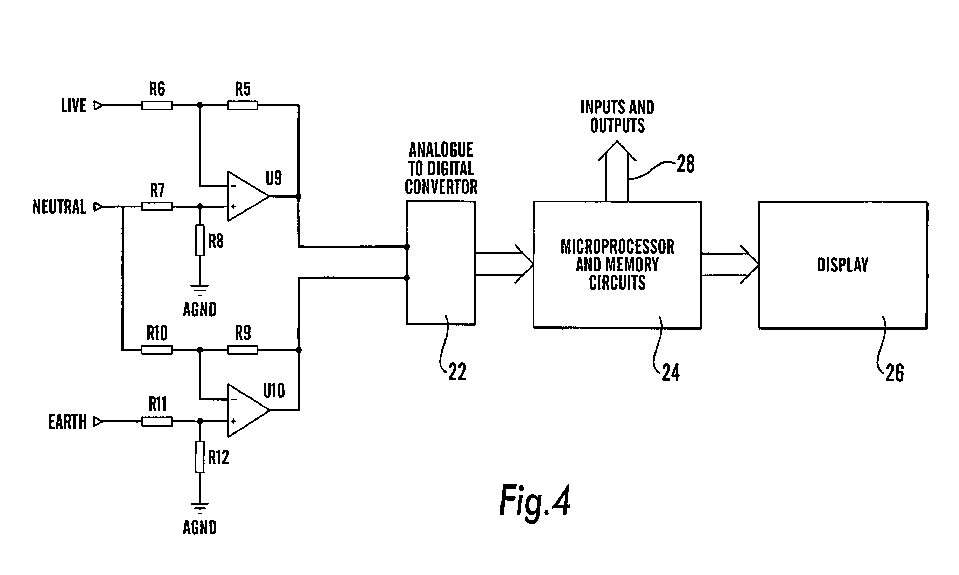

Referring to Figure 2, this illustrates a driving circuit for injecting the required low do current at the earth terminal (18) for determining neutral-earth loop resistance $R_{NE}$ and is only connected to the earth terminal (18) during a test via a relay 20, which allows the processor (Figure 4) to check the earth neutral voltage is within limits before performing a test. The current source consists of two symmetrical parts ($Q_1$, $Q_2$), one each for positive and negative polarities. The current sources ($Q_1$, $Q_2$) are driven from the processor (Figure 4) via drivers $U_1$, $U_2$ by a smooth square wave of variable mark-space ratio.

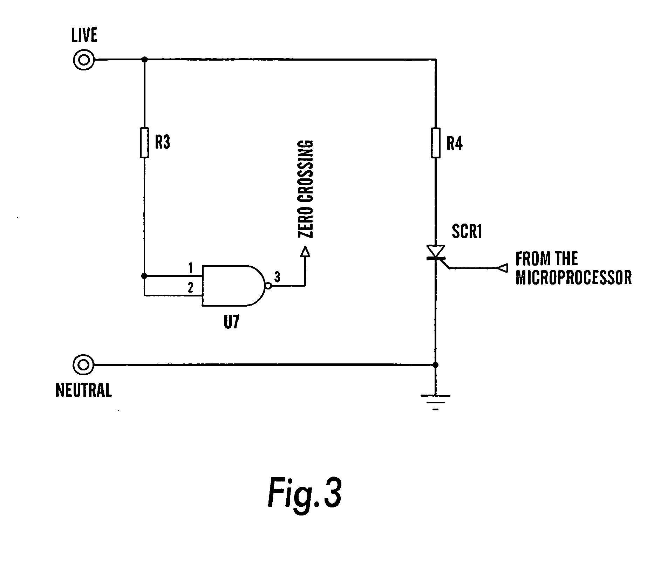

Figure 3 illustrates the line-neutral resistive loading circuit, for the high current part of the test which is used to determine $R_{LN}$ and $R_N$. This consists of a thyristor SCR1 in series with an appropriate low-value load resistor ($R_4$ e.g.22$\Omega$) which is fired by a signal from the processor (Figure 4). A Schmitt gate pack U7 generates a zero crossing signal from the mains supply, so that the loading and unloading can be applied on alternate half-cycles.

Figure 4 consists of the voltage measurement circuit, analogue to digital converter (22), microprocessor circuits (24) and display (26). There are two instrumentation amplifiers U9 and U10 of which U9 monitors the voltage between live and neutral, while U10 monitors the voltage between neutral and earth. The outputs of these amplifiers are then fed via a multiplexor to an analogue to digital converter. The analogue to digital converter is arranged to make measurements at a frequency considerably higher than the mains frequency and at a suitably high precision (16 bits).

The software in the microprocessor is arranged so that the loaded and unloaded half cycles can be measured (by integrating the A to D readings or some other filtering technique). Measurements are simultaneously made for both the line neutral, and neutral earth loops.

During the low current neutral earth test the software in the microprocessor arranges the analogue to digital converter to only measure the neutral earth voltage. Many readings are taken and digital filtering techniques are used to produce the voltage between the neutral and earth during the low current test.

The microprocessor combines these measurements to produce the line earth loop resistance, which is then shown on the display (26).

## Claims

1. A method of making a measurement of a line-earth impedance of a three-wire mains circuit comprising a line lead, a neutral lead and an earth lead, which three-wire mains circuit includes a residual current device such as an earth-leakage circuit breaker, which method comprises the steps of:

(a) measuring the respective voltages across the line-neutral circuit $V_{1(LN)}$ and the neutral-earth circuit $V_{1(NE)}$ in an unloaded state;
(b) connecting a suitable known load resistance $R_{LOAD}$ (12) across the line-neutral circuit, so as to cause a relatively high test current to flow, repeating both voltage measurements $V_{2(LN)}$, $V_{2(NE)}$ for the loaded state and calculating the value of the test current $I_1$ from the value of the load resistance and the measured line-neutral voltage $V_{2(LN)}$;
(c) dividing the respective changes in voltage $V_{1(LN)}$-$V_{2(LN)}$, $V_{1(NE)}$-$V_{2(NE)}$ by the test current $I_1$ to give the resistances of the line-neutral loop $R_{LN}$ and the neutral lead $R_N$-, **characterised by** the steps of:
(d) injecting a low DC current $I_2$ (14) into the neutral-earth circuit and measuring the new neutral-earth voltage $V_{3(NE)}$;
(e) dividing the change in neutral-earth voltage $V_{3(NE)}$- $V_{1(NE)}$ by $I_2$ to determine the neutral-earth loop resistance $R_{NE}$; and
(f) determining the line-earth loop resistance $R_{LE}$ from the sum of the line lead resistance $R_L$ and the earth lead resistance $R_E$ by calculating:

$$R_L = R_{LN} - R_{N'};$$

$$R_E = R_{NE} - R_N;$$

and

$$R_{LE} = R_L + R_E$$

**2.** A method according to claim 1 in which the method is carried out in two stages, (I) a high current line-neutral test and (2) a low current neutral-earth test.

**3.** A method according to claim 1 in which the loaded and unloaded measurements are made in at least two successive half cycles of a driving signal in order to minimise the effects of electrical noise on the supply voltage.

**4.** A method according to claim 3 in which three successive half cycles are used, the first and last half cycles being unloaded and averaged, and the middle half-cycle being loaded.

**5.** A method according to claim 1 in which the low current is below the trip level of the RCD or is ramped in such a way as to avoid tripping the RCD.

**6.** A method according to claim 5 in which the ramp rate is programmable.

**7.** A method according to claim 6 in which the DC voltage between neutral and earth is measured several times, and a linear regression and standard deviation are calculated in order to provide an indication of noise or drift in the DC level.

**8.** A test instrument for a three-wire mains circuit which includes a residual current device, **characterised in that** said test instrument is arranged to carry out a measurement method according to any preceding claim, and said test instrument comprises: a resistive loading circuit (SCR1, $R_4$, and said test instrument comprises: Figure 3); a low current driving circuit ($U_1$, $U_2$, $Q_1$, $Q_2$, Figure 2); means U9, U10, Figure 4) for monitoring the live-neutral and neutral-earth voltages respectively; an analogue-to-digital converter (22), a microprocessor (24) and a display (26).

**Patentansprüche**

**1.** Verfahren zum Durchführen einer Messung einer Leitung-Erde-Impedanz eines Dreileiter-Netzes, das einen Phasenleiter, einen Neutralleiter und einen Erde-Leiter enthält, wobei das Dreileiter-Netz eine Fehlerstromeinricht ung enthält , wie zum Be ispiel einen Erdschlußschutzschalter, und wobei das Verfahren die Schritte umfasst:

(a) Messen der jeweiligen Spannung über dem Phase-Neutral-Kreis $V_{1(LN)}$ und dem Neutral-Erde-Kreis $V_{1(NE)}$ in einem unbelasteten Zustand;

(b) Anschließen eines geeigneten bekannten Lastwiderstand $R_{LOAD}$ (12) über dem Phase-Neutral-Kreis, um somit zu bewirken, dass ein relativ starker Prüfstrom fließt, Wiederholen bei der Spannungsmessungen $V_{2(LN)}$, $V_{2(NE)}$ für den belasteten Zustand und Berechnen des Wertes des Prüfstroms $I_1$ aus dem Wert des Lastwiderstands und der gemessenen Phase-Neutral-Spannung $V_{2(LN)}$;

(c) Dividieren der jeweiligen Spannungsänderungen $V_{1(LN)}$ - $V_{2(LN)}$, $V_{1(NE)}$ - $V_{2(NE)}$ durch den Prüfstrom $I_1$, um die Widerstände der Phase-Neutral-Schleife $R_{LN}$ und des Neutralleiters $R_N$ zu erhalten; **gekennzeichnet durch** die Schritte:

(d) Einkoppeln eines schwachen Gleichstroms $I_2$ (14) in den Neutral-Erde-Kreis und Messen der neuen Neutral-Erde-Spannung $V_{3(NE)}$;

(e) Dividieren der Neutral-Erde-Spannungsänderung $V_{3(NE)}$- $V_{1(NE)}$ durch $I_2$, um den Neutral-Erde-Schleifenwiderstand $R_{NE}$ zu bestimmen; und

(f) Bestimmen des Phase-Erde-Schleifenwiderstands $R_{LE}$ aus der Summe aus dem Phasenleiterwiderstand $R_L$ und den Erdleitungswiderstand $R_E$, indem berechnet wird:

$$R_L = R_{LN} - R_N;$$

$$R_E = R_{NE} - R_N;$$

und

$$R_{LE} = R_L + R_E$$

**2.** Verfahren nach Anspruch 1, bei dem das Verfahren in zwei Stufen ausgeführt wird, (1) einem Starkstrom-Phase-Neutral-Test und (2) einem Schwachstrom-Neutral-Erde-Test.

**3.** Verfahren nach Anspruch 1, wobei die belasteten und unbelasteten Messungen in wenigstens zwei aufeinanderfolgenden Halbzyklen eines Ansteuersignals durchgeführt werden, um die Auswirkungen elektrischer Störungen auf der Netzleitung zu minimieren.

**4.** Verfahren nach Anspruch 3, bei dem drei aufeinanderfolgende Halbzyklen verwendet werden, wobei der erste und der letzte Halbzyklus unbelastet und gemittelt sind, und wobei der mittlere Halbzyklus belastet ist.

**5.** Verfahren nach Anspruch 1, bei dem der schwache Strom unterhalb des Auslösepegels der Fehlerstromeinrichtung liegt oder in einer solchen Weise mit Rampen versehen ist, dass ein Auslösen der Fehlerstromeinrichtung vermieden wird.

**6.** Verfahren nach Anspruch 5, bei dem die Rampensteilheit programmierbar ist.

**7.** Verfahren nach Anspruch 6, bei dem die Gleichspannung zwischen Neutralleiter und Erde mehrmals gemessen wird und eine lineare Regression und eine Standardabweichung berechnet werden, um eine Angabe einer Störung oder Drift im Gleichspannungspegel zur Verfügung zu stellen.

**8.** Prüfgerät für ein Dreileiter-Netz, das eine Fehlerstromeinrichtung enthält, **dadurch gekennzeichnet, dass** das Prüfgerät dafür ausgelegt ist, ein Messverfahren nach irgendeinem der vorangehenden Ansprüche auszuführen, und das Prüfgerät umfasst: eine Widerstands-Belastungsschaltung (SCR1, $R_4$, Fig. 3); eine Schwachstromansteuerschaltung ($U_1$, $U_2$, $Q_1$, $Q_2$ Fig. 2); Mittel (U9, U10, Fig. 4) zum Überwachen der Phase-Neutral- bzw. Neutral-Erde-Spannungen; einen Analog-zu-Digital-Wandler (22), einen Mikroprozessor (24) und eine Anzeigevorrichtung (26).

## Revendications

**1.** Procédé de mesure d'impédance phase-terre d'un circuit secteur triphasé comprenant un fil de phase, un fil neutre et un fil de terre, le circuit secteur triphasé comprenant un dispositif à courant résiduel tel qu'un disjoncteur de fuite à la terre ; le procédé comprenant les étapes consistant à :

(a) mesurer les tensions respectives présentes à vide dans le circuit phase-neutre $V_{1(LN)}$ et dans le circuit neutre-terre $V_{1(NE)}$ ;
(b) placer une résistance de charge de valeur connue et appropriée $R_{LOAD}$(12) sur le circuit phase-neutre de manière à faire passer un courant d'essai relativement élevé, répéter sous tension les deux mesures de tension $V_{2(LN)}$, $V2_{(NE\backslash)}$ et calculer la valeur du courant d'essai $I_1$ à partir de la valeur de la résistance de charge et de la tension phase-neutre $V_{2(LN)}$ mesurée ;
(c) diviser les différences de tension respectives $V_{1(LN)}$ - $V_{2(LN)}$ et $V_{1(NE)}$ - $V_{2(NE)}$ par le courant d'essai $I_1$ pour obtenir la résistance de la boucle phase neutre $R_{LN}$ et celle du fil neutre $R_N$ ; **caractérisé par** les étapes consistant à :
(d) envoyer un faible courant continu $I_2$ (14) dans le circuit neutre-terre et mesurer la nouvelle tension neutre-terre $V_{3(NE)}$ ;
(e) diviser la différence de tension neutre-terre $V_{3(NE)}$ - $V_{1(NE)}$ par $I_2$ pour déterminer la résistance de la boucle neutre-terre $R_{NE}$ ; et
(f) déterminer la résistance de la boucle phase-terre $R_{LE}$ en additionnant la résistance du fil de phase $R_L$ et la résistance du fil de terre $R_E$ à partir des calculs :

$$R_L = R_{LN} - R_N \ ;$$

$$R_E = R_{NE} - R_N \ ;$$

et

$$R_{LE} = R_L + R_E$$

**2.** Procédé selon la revendication 1, consistant à procéder en deux étapes : (1) un essai de courant élevé phase-neutre et (2) un essai de courant faible neutre-terre.

**3.** Procédé selon la revendication 1, dans lequel les mesures sous tension et à vide sont effectuées en au moins deux demi-cycles successifs d'un signal de commande, afin de minimiser l'incidence du bruit électrique sur la tension d'alimentation.

**4.** Procédé selon la revendication 3, dans lequel trois demi-cycles successifs sont utilisés : le premier et le dernier demi-cycles étant à vide et moyennés, et le demi-cycle intermédiaire étant sous tension.

**5.** Procédé selon la revendication 1, dans lequel le courant faible est inférieur au seuil de déclenchement du dispositif à courant résiduel, ou varie en rampe sans pour autant déclencher ce dispositif.

**6.** Procédé selon la revendication 5, dans lequel la variation de rampe est programmable.

**7.** Procédé selon la revendication 6, dans lequel on mesure plusieurs fois la tension continue entre le neutre et la terre, et où l'on calcule la régression linéaire et l'écart-type afin de fournir une indication du bruit ou de la dérive du niveau en courant continu.

8. Instrument testeur pour un circuit secteur triphasé comprenant un dispositif à courant résiduel, **caractérisé en ce que** ledit instrument testeur est conçu pour appliquer un procédé de mesure selon l'une quelconque des revendications précédentes, et **en ce que** ledit instrument testeur comprend : un circuit de charge résistive (SCR1, $R_4$, Figure 3) ; un circuit conducteur de courant faible ($U_1$, $U_2$, $Q_1$, $Q_2$, Figure 2) ; des moyens (U9, U10, Figure 4) destinés à surveiller les tensions phase-neutre et neutre-terre respectivement ; un convertisseur analogique/ numérique (22), un microprocesseur (24) et un écran (26).

## Fig. 1

RL LINE RESISTANCE

LINE

4

R LOAD

12

RN NEUTRAL RESISTANCE

NEUTRAL

6

I DC

14

RE EARTH RESISTANCE

EARTH

10

2

8 SUB STATION

*Fig. 1*

## Fig. 2

POSITIVE SUPPLY

R1

Q1    U1    FROM THE MICROPROCESSOR

EARTH1    RL1    20

18

Q2    U2    FROM THE MICROPROCESSOR

R2

*Fig. 2*

NEGATIVE SUPPLY

Fig.3

Fig.4

**EP 1 306 682 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0295800 B
- US 6288553 A